# EUROPÄISCHE PATENTSCHRIFT

(11) **EP 2 286 461 B1**
(45) Veröffentlichungstag und Bekanntmachung des Hinweises auf die Patenterteilung: **05.12.2012**
(21) Anmeldenummer: 09738007.5
(22) Anmeldetag: 16.04.2009
(51) Int. Cl.: H01L 31/048

(54) **PHOTOVOLTAIKMODULE ENTHALTEND PLASTIFIZIERTE ZWISCHENSCHICHT-FOLIEN MIT HOHEM ALKALITITER**
PHOTOVOLTAIC MODULES CONTAINING PLASTICIZED INTERMEDIATE LAYER FILMS WITH HIGH ALKALI TITRE
MODULES PHOTOVOLTAÏQUES CONTENANT DES FEUILLES PLASTIFIÉES AYANT FONCTION DE COUCHE INTERMÉDIAIRE, À TITRE ALCALIN ÉLEVÉ

(30) Priorität: 30.04.2008 DE 102008001507
(43) Veröffentlichungstag der Anmeldung: 23.02.2011
(73) Patentinhaber: Kuraray Europe GmbH, 65795 Hattersheim (DE)
(72) Erfinder: KOLL, Bernhard, 53757 St. Augustin (DE)
(74) Vertreter: Kisters, Michael Marcus
(86) Internationale Anmeldenummer: PCT/EP2009/054511
(87) Internationale Veröffentlichungsnummer: WO 2009/132963

(56) Entgegenhaltungen:
- EP-A1- 1 762 550
- EP-A1- 1 785 404
- EP-A2- 0 227 633
- EP-A2- 1 617 487
- WO-A1-03/033583
- WO-A2-01/79305
- WO-A2-2009/047222
- WO-A2-2009/047223
- WO-A2-2009/071703
- DE-A1- 19 756 274
- GB-A- 1 052 697

## Beschreibung

Die Erfindung betrifft die Herstellung von Photovoltaikmodulen unter Verwendung von weichmacherhaltigen Folien auf Basis von Polyvinylacetal mit hohem Alkalititer zur Vermeidung von Korrosion an den photosensitiven Halbleiterschichten.

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf ein Substrat wie z.B. eine transparente Platte oder eine flexible Trägerfolie z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, UVstabil und Feuchtigkeitsunempfindlich sein und nach dem Laminierprozess vollständig blasenfrei sein.

Als transparente Kleber werden häufig aushärtende Gießharze oder vernetzbare, auf Ethylenvinylacetat (EVA) basierende Systeme eingesetzt, so wie beispielsweise in DE 41 22 721 C1 oder DE 41 28766 A1 offenbart. Diese Klebesysteme können im ungehärteten Zustand so niedrigviskos eingestellt werden, dass sie die Solarzelleneinheiten blasenfrei umschließen. Nach Zugabe eines Härters oder Vernetzungsmittels wird eine mechanisch widerstandfähige Klebeschicht erhalten. Nachteilig diesen Klebesystemen ist, dass beim Aushärteprozess häufig aggressive Substanzen wie Säuren freigesetzt werden, die die photosensitiven Halbleiterschichten, insbesondere Dünnschichtmodule, zerstören können. Zudem neigen einige Gießharze nach einigen Jahren zur Blasenbildung bzw. Delamination durch UV-Strahlung.

Eine Alternative zu aushärtenden Klebesystemen ist der Einsatz von weichmacherhaltigen Folien auf Basis von Polyvinylacetalen wie das aus der Verbundglasherstellung bekannte Polyvinylbutyral (PVB). Die Solarzelleneinheiten werden mit einer oder mehreren PVB-Folien bedeckt und diese unter erhöhtem Druck und erhöhter Temperatur mit den gewünschten Abdeckmaterialien zu einem Laminat verbunden.

Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2 oder US 4,321,418 bekannt. Die Verwendung von PVB-Folien in Solarmodulen als Verbundsicherheitsverglasungen ist z.B. in DE 20 302 045 U1, EP 1617487 A1, und DE 35 389 86 C2 offenbart. Diese Schriften enthalten aber keine Information über die mechanischen, chemischen und elektrischen Eigenschaften der verwendeten PVB-Folien.

Insbesondere die elektrischen Eigenschaften der Folien werden mit zunehmender Leistungsfähigkeit der photosensitiven Halbleiterschichten und der weltweiten Verbreitung von Solarmodulen immer wichtiger. Ladungsverluste oder gar Kurzschlüsse der Halbleiterschicht müssen auch unter extremen Witterungsbedingungen wie tropische Temperaturen, hohe Luftfeuchtigkeit oder starke UV-Strahlung über die gesamte Lebensdauer des Moduls vermieden werden. Photovoltaikmodule werden nach IEC 61215 einer Vielzahl von Tests unterzogen (Damp heat test, wet leakage current test) um Verlustströme der Module zu reduzieren.

Es ist bekannt, dass der elektrische Widerstand von PVB-Folien mit steigendem Feuchtegehalt steil abfällt, was das Auftreten von Leckströmen in Photovoltaikmodulen stark begünstigt. Im Randbereich des Photovoltaikmoduls sind die Folien als Einkapselungsmaterial zur Umgebung offen und den Umweltbedingungen wie z.B. hohen Umgebungsfeuchten ausgesetzt. Hierdurch kann der Wassergehalt der Folien im Randbereich stark zunehmen und Werte bis zur Gleichgewichtsfeuchte (ca. 3 Gew. %) annehmen. Der erhöhte Wassergehalt im Randbereich der Folie reduziert deren elektrischen Widerstand in diesem Bereich stark. Der Wassergehalt nimmt zwar zur Folienmitte wieder ab, aber zur Vermeidung von Leckströmen können die photosensitiven Halbleiterschichten daher nicht bis in den Randbereich der Folie bzw. des Moduls verlegt werden. Dies reduziert die Flächenbelegung und damit die Stromausbeute des Moduls.

Solarzellen, insbesondere photosensitive Halbleiterschichten von Dünnschicht-Solarmodulen, z.B. auf Basis von CIS (Copper/Indium/(di)Selenit) oder Copper/Indium/Gallium/Sulphide/Selenit (CIGS) oder die als elektrischer Leiter eingesetzten dünnen Schichten (TCO, "transparent conductive oxide") sind chemisch korrosionsanfällig. Das Einkapselungsmaterial muss daher weitestgehend chemisch innert sein und darf keine aggressiven chemischen Additive wie Vernetzer, Crosslinker oder Primer enthalten. Weiterhin ist die Anwesenheit von Wasser oder Säurespuren zu vermeiden.

WO 2009/047222 A2, WO 2009047223 A2 und WO 2009/071703 A2 offenbaren Photovoltaikmodule enthaltend weichmacherhaltige, auf Polyvinylacetal basierende Folien, wobei diese Folien Haftungsregulatoren in Form von Alkali- oder Erdalkalisalze von organischen Säuren in einer Konzentration von weniger als 50 ppm Metallionen enthalten. Salzarme Folien d.h. solche mit niedrigem Alkalititer besitzen einen niedrigen Durchgangswiderstand und sind für Photovoltaikmodule besonders geeignet.

Photovoltaikmodule mit weichmacherhaltigen, auf Polyvinylacetal basierende Folien enthaltend einen hohen Salzgehalt in Form von Metallsalzen einer Carbonsäure als Antihaftmittel sind aus EP 1617489 A2 bekannt. Folien dieser Art haben aufgrund des hohen Salzgehaltes einen nicht zufriedenstellenden Durchgangswiderstand.

Aus einem anderen technischen Gebiet, nämlich der Verbundglasherstellung sind weichmacherhaltige Polyvinylacetal-Folien enthaltend SiO₂ zur Verbesserung der Haftung (DE 19756274), der Feuchteresistenz (EP 1785404) oder zur Flammhemmung (EP 0227633) bekannt. Der Einsatz dieser Folien in Photovoltaikmodulen ist nicht beschrieben.

Aufgabe der vorliegenden Erfindung war es daher, weichmacherhaltige Folien auf Basis von Polyvinylacetal mit geringer Korrosionsneigung gegenüber photosensitiven Halbleiterschichten oder den verwendeten elektrischen Leitern bereit zu stellen.

Es wurde gefunden, dass Folien auf Basis von Polyvinylacetalen mit hohem Alkalititer und einem Anteil an SiO₂ eine verringerte Korrosionsneigung gegenüber photosensitiven Halbleiterschichten oder den verwendeten elektrischen Leitern aufweisen.

Ohne an die Richtigkeit dieser Theorie gebunden zu sein, ist die verringerte Korrosionsneigung möglicherweise drauf zurückzuführen, dass die mit einem erhöhtem Alkalititer einhergehende höhere Basizität der PVB-Folie durch Alterungsprozesse freigesetzte Säure neutralisiert, welche ohne Neutralisation die Zerstörung säureempfindlicher Halbleiterschichten auslöst.

Gegenstand der vorliegenden Erfindung sind daher Photovoltaikmodul, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung
wobei die weichmacherhaltige, auf Polyvinylacetal basierende Folie c) einen Alkali-Titer von mehr als 30 durch Zugabe von 0.05 bis 1 Gew.% eines Metallsalzes einer Carbonsäure mit 1 bis 15 Kohlenstoffatomen als basische Verbindung und 0.001 bis 5 Gew.% SiO₂ aufweist.

Bevorzugt weisen die erfindungsgemäß eingesetzten Folien daher eine gewisse Basizität, ausgedrückt als Alkali-Titer auf, der über 40 liegen kann. Ein maximaler Alkalititer von 100 sollte nicht überschritten werden.

Der Alkali-Titer wird, wie im folgenden beschrieben, durch Rücktitration der Folie bestimmt und kann durch Zugabe von basischen Substanzen, wie z.B. Metallsalze von organischen Carbonsäuren mit 1 bis 15 Kohlenstoffatomen, insbesondere Alkali- oder Erdalkalisalze wie Magnesium- oder Kaliumacetat oder NaOH, KOH oder Mg(OH)₂ eingestellt werden. Die basische Verbindung wird üblicherweise in einer Konzentration von 0,05 bis 1 Gew.%, bezogen auf die gesamte Mischung eingesetzt.

Eine weitere Möglichkeit, die Korrosionsneigung der erfindungsgemäß eingesetzten Folien gegenüber photosensitiven Halbleiterschichten zu verringern, ist die Vermeidung von Säurespuren bei der Herstellung des Materials. Folien dieser Art werden durch Extrusion unter erhöhten Temperaturen hergestellt, wodurch eine thermische Zersetzung des polymeren Materials bzw. des Weichmachers auftreten kann. Weiterhin kann durch eindiffundiertes Wasser eine Spaltung der Restacetatgruppen des Polyvinylacetals auftreten, wodurch Essigsäure freigesetzt wird. In beiden Fällen resultieren Säurespuren, die die photosensitiven Halbleiterschichten angreifen können.

Bevorzugt weisen die erfindungsgemäß eingesetzten Folien bei einer Umgebungsfeuchte von 85% rF bei 23°C einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Zur Herstellung von Polyvinylacetal wird Polyvinylalkohol in Wasser gelöst und mit einem Aldehyd wie Butyraldehyd unter Zusatz eines Säurekatalysators acetalisiert. Das ausgefallene Polyvinylacetals wird abgetrennt, neutral gewaschen, ggf. in einem alkalisch eingestellten wässrigen Medium suspendiert, danach erneut neutral gewaschen und getrocknet.

Die zur Acetalisierung eingesetzte Säure muss nach erfolgter Reaktion wieder neutralisiert werden. Wird hier ein Überschuss an Base (z.b. NaOH, KOH oder Mg(OH)₂) eingesetzt, so erhöht sich der Alkalititer und es kann ganz oder teilweise auf die Zugabe der basischen Substanz verzichtet werden.

Der Polyvinylalkoholgehalt des Polyvinylacetals kann durch die Menge des bei der Acetalisierung eingesetzten Aldehyds eingestellt werden. Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvemetztes Polyvinylbutyral (PVB), das durch Acetalisierung von Polyvinylalkohol mit Butyraldehyd gewonnen wird.

Der Einsatz von vemetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 22 Gew.%, 20 Gew.% oder 18 Gew.%, weniger als 16 Gew.% oder 15 Gew.% und insbesondere weniger als 14 Gew.% auf. Ein Polyvinylalkoholanteil von 12 Gew.% sollte nicht unterschritten werden.

Der Polyvinylacetatgehalt des erfindungsgemäß eingesetzten Polyvinylacetals liegt bevorzugt unter 3 Gew.% oder unter 1 Gew.%, besonders bevorzugt unter 0,75 Gew.%, ganz besonders bevorzugt unter 0,5 Gew.% und insbesondere unter 0,25 Gew.%.

Aus dem Polyvinylalkoholanteil und dem Restacetatgehalt kann der Acetalisierungsgrad rechnerisch ermittelt werden.

Bevorzugt weisen die Folien einen Weichmachergehalt von maximal 40 Gew.%, 35 Gew.%, 32 Gew.%, 30 Gew.%, 28 Gew.%, 26 Gew.%, 24 Gew.% oder 22 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere Weichmacher enthalten.

Geeignete Weichmacher für die erfindungsgemäß eingesetzten Folien sind eine oder mehrere Verbindungen ausgewählt aus den folgenden Gruppen:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykol-bis-(2-ethylhexanoat), Triethylenglykol-bis-(2-ethyl-hexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Besonders geeignet als Weichmacher für die erfindungsgemäß eingesetzten Folien sind eine oder mehrere Verbindungen ausgewählt aus der folgende Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), Diisononylcyclohexandicarbonsäureester (DINCH) und Dipropylenglykolbenzoat.

Ganz besonders geeignet als Weichmacher für die erfindungsgemäß eingesetzten Folien sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle 1 zeigt erfindungsgemäß einsetzbare Weichmacher und deren Polaritätswerte nach der Formel 100 x O/(C+H).

**Tabelle 1**

| Name | Polaritätswert |
|---|---|
| Di-2-ethylhexylsebacat (DOS) | 5,3 |
| Diisononylcyclohexandicarbonsäureester (DINCH) | 5,4 |
| Di-2-ethylhexyladipat (DOA) | 6,3 |
| Di-2-ethylhexylphthalat (DOP) | 6,5 |
| Triethylenglykol-bis-2-propylhexanoat | 8,6 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |

Weiterhin kann die möglicherweise vom Wassergehalt der Folie abhängende Ionenbeweglichkeit und damit der spezifische Widerstand durch den Zusatz von SiO₂, insbesondere pyrogener Kieselsäure beeinflusst werden. Bevorzugt enthalten die weichmacherhaltigen, auf Polyvinylacetal basierenden 2 bis 5 Gew.% SiO₂.

Weiterhin können die erfindungsgemäßen Folien zusätzlich auch übliche Additive, wie zum Beispiel Oxidationsstabilisatoren, UV-Stabilisatoren, Farbstoffe, Pigmente sowie Antihaftmittel enthalten.

Die prinzipielle Herstellung und Zusammensetzung von Folien auf Basis von Polyvinylacetalen ist z. B. in EP 185 863 B1, EP 1 118 258 B1, WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

In einer Variante der erfindungsgemäßen Photovoltaikmodule werden die photosensitiven Halbleiterschichten auf die Abdeckung d) aufgebracht (z.B. durch Aufdampfen, Gasphasenabscheidung, Sputtern oder Nassabscheidung) und durch eine Folie c) mit der transparenten Frontabdeckung a) verklebt.

In einer anderen Variante werden die photosensitiven Halbleiterschichten auf die transparente Frontabdeckung a) aufgebracht und durch die Folie c) mit der rückwärtigen Abdeckung d) verklebt.

Alternativ können die photosensitiven Halbleiterschichten zwischen zwei Folien c) eingebettet und so mit den Abdeckungen a) und d) verklebt werden.

Die Dicke der auf weichmacherhaltigem Polyvinylacetal basierenden Folien liegt üblicherweise bei 0.38, 0.51, 0.76, 1.14, 1.52 oder 2.28 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung a) besteht in der Regel aus Glas oder PMMA. Die rückwärtige Abdeckung d) (sog. Backsheet) des erfindungsgemäßen Photovoltaikmoduls kann aus Glas, Kunststoff oder Metall oder deren Verbünden bestehen, wobei einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Bei Dünnschicht-Solarmodulen ist die photosensitive Halbleiterschicht direkt auf einen Träger aufgebracht. Eine Einkapselung ist hier nicht möglich. Daher wird der Schichtkörper aus einem Träger (z. B. der rückwärtigen Abdeckung) mit der photosensitiven Halbleiterschicht und der transparenten Frontabdeckung durch mindestens eine zwischen gelegte, auf weichmacherhaltigem Polyvinylacetal basierende erfindungsgemäße Folie zusammengelegt und durch diese bei erhöhter Temperatur verklebt. Alternativ kann die photosensitive Halbleiterschicht auf die transparente Frontabdeckung als Träger aufgebracht und mit der der rückwärtigen Abdeckung durch mindestens eine zwischen gelegte, auf weichmacherhaltigem Polyvinylacetal basierende erfindungsgemäße Folie verklebt sein.

Zur Laminierung der so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C, insbesondere 130 -160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Weiterhin ist Gegenstand der Erfindung die Verwendung von weichmacherhaltigen, auf Polyvinylacetal basierenden Folien, die einen Alkali-Titer von mehr als 30 durch Zugabe von 0.05 bis 1 Gew.% eines Metallsalzes einer Carbonsäure mit 1 bis 15 Kohlenstoffatomen als basische Verbindung aufweisen und 0.001 bis 5 Gew.% SiO₂ enthalten, zur Herstellung von Photovoltaikmodulen.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

### Messmethoden:

Die Messung des spezifischen Durchgangswiderstandes der Folie erfolgt gemäß DIN IEC 60093 bei definierter Temperatur und Umgebungsfeuchte (23 °C und 85% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit R_{z} bei Messung nach DIN EN ISO 4287 nicht größer als 10 mm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspekroskopie (AAS).

Der Wasser- bzw. Feuchtegehalt der Folien wird mit der Karl-Fischer-Methode bestimmt. Diese Methode kann sowohl an der unlaminierten Folie als auch an einem laminierten Photovoltaikmodul in Abhängigkeit vom Abstand zum Rand der Folie durchgeführt werden.

Alkali-Titer

3 bis 4 gr. des weichmacherhaltigen Polyvinylacetal-Films wird in 100 ml einer Mischung von Ethanol/THF (80:20) in einem Magnetrührer über Nacht gelöst. Hierzu werden 10 ml einer verdünnten Salzsäure (c=0,01 mol/Liter) gegeben und anschließend potentiometrisch mit einer Lösung von Tetrabutylammoniumhydroxid (TBAH) in 2-Propanol (c=0,01 mol/Liter) mit einem Titroprozessor gegen eine Leerprobe potentiometrisch titriert. Der Alkali-Titer berechnet sich wie folgt:

Alkali-Titer = ml HCl pro 100 gr einer Probe = (Verbrauch TBAH Leerprobe - TBAH Probe x 100 durch Gewicht der Probe in gr.)

Der Damp-Heat Test wird gemäß IEC 61646 durchgeführt.

### Beispiele

Es wurden Substratgläser der Abmessung 30 x 30 cm mit darauf abgeschiedenen, funktionsfähig kontaktierten Dünnschichtzellen (CIS) im Laminatorverfahren mit einem Deckglas durch PVB-Folien verklebt. Nach einer ersten Light-Soak-Behandlung (Equilibrierung) wurde die Ausgangsleistung (Photostromausbeute) der Testmodule ermittelt. Nach 1000h Damp-Heat Belastung (85% RF, 85°C) wurde erneut equilibriert und die Photostromausbeute bestimmt.

Photovoltaikmodule können durch Randeinflüsse, wie zum Beispiel Eindringen von Feuchtigkeit, können Module einen Teil Ihrer Leistung verlieren. Dies betrifft die erfindungsgemäßen Module und die Vergleichsmodule in gleichem Maße.

Zusätzlich kommen Korrosionseffekte, welche von der Alkalinität der Folie abhängen. Tabelle 2 und 3 zeigen, das erfindungsgemäße Module zwar einen Leistungsverlust aufweisen, dieser aber deutlich geringer ausfällt als bei Modulen die mit Folien mit niedrigem Alkalititer hergestellt wurden. Dieser Effekt lässt sich durch die Anwesenheit von SiO₂ noch weiter verbessern.

Die Mengenangaben in Tabelle 2 und 3 sind in Gew.% angegeben, bezogen auf die Summe PVB und Weichmacher. 3G8 steht für Triethylenglykol-bis-2-ethylhexanoat, AEROSIL 130 und TINUVIN 328 sind Handelsprodukte der Evonik Degussa GmbH bzw. CIBA. Der Leistungsverlust wird an einem CIS-Modul nach 1000h damp-heat Test in % und der Durchgangswiderstand nach DIN IEC 60093 an einer bei 23°C/85%rF klimatisierten Folie in Ohm angegeben (wie oben beschrieben).

**Tabelle 2**

| Beispiel | VB1 | VB2 | VB3 | B1 |
|---|---|---|---|---|
| Kurzbeschreibung | Geringer Alkalititer | mit 250 ppm NaAc | Hoher AT aus PVB | 2% SiO2, geringer AT |
| PVB | 76 | 76 | 76 | 78 |
| 3G8 | 24 | 24 | 24 | 22 |
| AEROSIL 130 | 0 | 0 | 0 | 2 |
| TINUVIN 328 | 0,15 | 0,15 | 0,15 | 0,15 |
| *Natriumacetat | 0 | 0,025 | 0 | 0 |
| MgAc2*4H2O | 0 | 0 | 0 | 0 |
| PVOH in PVB | 18.0 | 18.0 | 18.2 | 20,3 |
| Alkalititer PVB | 5 | 5 | 22 | 7 |
| Alkalititer Folie | 3 | 27 | 17 | 0 |
| Leistungverlust | 34% | 16% | 21% | 27% |
| Durchgangswiderstand | 3,9E+11 | 2,5E+11 | 3,2E+11 | 4,5E+12 |

**Tabelle 3**

| Beispiel | B2 | B3 |
|---|---|---|
| Kurzbeschreibung | 2% SiO2, hoher AT | 2% SiO2, hoher AT |
| PVB | 78 | 78 |
| 3G8 | 22 | 22 |
| AEROSIL 130 | 2 | 2 |
| TINUVIN 328 | 0,15 | 0,15 |
| *Natriumacetat | 0,05 | 0 |
| MgAc2*4H2O | 0 | 0,05 |
| PVOH in PVB | 20,3 | 20,3 |
| Alkalititer PVB | 7 | 7 |
| Alkalititer Folie | 36 | 24 |
| Leistungverlust | 12% | 14% |
| Durchgangswiderstand | 3,2E+12 | 6,5E+12 |

## Patentansprüche

1. Photovoltaikmodul, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung
**dadurch gekennzeichnet, dass** die weichmacherhaltige, auf Polyvinylacetal basierende Folie c) einen Alkali-Titer von mehr als 30 durch Zugabe von 0.05 bis 1 Gew.% eines Metallsalzes einer Carbonsäure mit 1 bis 15 Kohlenstoffatomen als basische Verbindung und 0.001 bis 5 Gew.% SiO₂ aufweist.

2. Photovoltaikmodul nach Anspruch 1 **dadurch gekennzeichnet, dass** die weichmacherhaltigen, auf Polyvinylacetal basierenden Folien c) einen Weichmachergehalt von maximal 40 Gew.% aufweisen.

3. Photovoltaikmodul nach Anspruch 1 oder 2 **dadurch gekennzeichnet, dass** das die weichmacherhaltigen, auf Polyvinylacetal basierenden Folien c) in einem Umgebungsklima von 85% rF/23°C einen elektrischen Durchgangswiderstand von mehr als 1E11 Ohm*cm aufweisen.

4. Photovoltaikmodul nach einem der Ansprüche 1 bis 3 **dadurch gekennzeichnet, dass** das Polyvinylacetal einen Polyvinylacetatgehalt von weniger als 3 Gew.% aufweist.

5. Photovoltaikmodul nach einem der Ansprüche 1 bis 4 **dadurch gekennzeichnet, dass** das Polyvinylacetal einen Polyvinylalkoholanteil von weniger als 22 Gew.% aufweist.

6. Photovoltaikmodul nach einem der Ansprüche 1 bis 5 **dadurch gekennzeichnet, dass** eine oder mehrere photosensitive Halbleiterschichten b) auf eine transparente Frontabdeckung a) aufgebracht werden und durch mindestens eine weichmacherhaltige, auf Polyvinylacetal basierende Folie c) mit der rückwärtigen Abdeckung d) verklebt sind.

7. Photovoltaikmodul nach einem der Ansprüche 1 bis 5 **dadurch gekennzeichnet, dass** eine oder mehrere photosensitive Halbleiterschichten b) auf eine rückwärtige Abdeckung d) aufgebracht werden und durch mindestens eine weichmacherhaltige, auf Polyvinylacetal basierende Folie c) mit der transparenten Frontabdeckung a) verklebt sind.

8. Photovoltaikmodul nach einem der Ansprüche 1 bis 5 **dadurch gekennzeichnet, dass** eine oder mehrere photosensitive Halbleiterschichten b) zwischen zwei Folien c) eingebettet und mit den Abdeckungen a) und d) verklebt werden.

9. Verwendung von weichmacherhaltigen, auf Polyvinylacetal basierenden Folien, die einen Alkali-Titer von mehr als 30 durch Zugabe von 0.05 bis 1 Gew.% eines Metallsalzes einer Carbonsäure mit 1 bis 15 Kohlenstoffatomen als basische Verbindung aufweisen und 0.001 bis 5 Gew.% SiO₂ enthalten, zur Herstellung von Photovoltaikmodulen.

10. Verwendung von Photovoltaikmodulen nach einem der Ansprüche 1 bis 7 als Fassadenbauteil, Dachflächen, Wintergartenabdeckung, Schallschutzwand, Balkon- oder Brüstungselement oder als Bestandteil von Fensterflächen.

## Claims

1. A photovoltaic module comprising a laminate formed from
a) a transparent front covering
b) one or more photosensitive semiconductor layers
c) at least one plasticiser-containing film based on polyvinyl acetal, and
d) a rear covering,
**characterised in that** the plasticiser-containing film based on polyvinyl acetal c) has an alkali titre of more than 30 by addition of 0.05 to 1 % by weight of a metal salt of a carboxylic acid containing 1 to 15 carbon atoms as an alkaline compound and 0.001 to 5 % by weight of SiO₂.

2. The photovoltaic module according to Claim 1, **characterised in that** the plasticiser-containing films based on polyvinyl acetal c) have a plasticiser content of at most 40 % by weight.

3. The photovoltaic module according to Claim 1 or 2, **characterised in that** the plasticiser-containing films based on polyvinyl acetal c) have an electrical volume resistivity of more than 1E11 ohm*cm in an ambient climate of 85 % RH/23 °C.

4. The photovoltaic module according to one of Claims 1 to 3, **characterised in that** the polyvinyl acetal has a polyvinyl acetate content of less than 3 % by weight.

5. The photovoltaic module according to one of Claims 1 to 4, **characterised in that** the polyvinyl acetal has a polyvinyl alcohol proportion of less than 22 % by weight.

6. The photovoltaic module according to one of Claims 1 to 5, **characterised in that** one or more photosensitive semiconductor layers b) is/are applied to a transparent front covering a) and is/are bonded to the rear covering d) by at least one plasticiser-containing film based on polyvinyl acetal c).

7. The photovoltaic module according to one of Claims 1 to 5, **characterised in that** one or more photosensitive semiconductor layers b) is/are applied to a rear covering d) and is/are bonded to the transparent front covering a) by at least one plasticiser-containing film based on polyvinyl acetal c).

8. The photovoltaic module according to one of Claims 1 to 5, **characterised in that** one or more photosensitive semiconductor layers b) is/are embedded between two films c) and is/are bonded to the coverings a) and d).

9. Use of plasticiser-containing films based on polyvinyl acetal, which have an alkali titre of more than 30 by addition of 0.05 to 1 % by weight of a metal salt of a carboxylic acid containing 1 to 15 carbon atoms as an alkaline compound and which contain 0.001 to 5 % by weight of SiO₂, for producing photovoltaic modules.

10. Use of photovoltaic modules according to one of Claims 1 to 7 as a façade component, roof areas, winter garden covering, sound-insulating wall, balcony or balustrade element or as a component of window areas.

## Revendications

1. Module photovoltaïque, comprenant un laminé
a) d'un recouvrement frontal transparent
b) d'une ou de plusieurs couche(s) photosensible(s) de semi-conducteurs
c) d'au moins un film contenant un plastifiant, basé sur de l'acétal de polyvinyle et
d) d'un recouvrement arrière
**caractérisé en ce que** le film c) contenant un plastifiant, basé sur de l'acétal de polyvinyle présente un titre alcalin supérieur à 30 par ajout de 0.05 à 1 % en poids d'un sel métallique d'un acide carboxylique avec de 1 à 15 atomes de carbone en tant que composé basique et de 0.001 à 5 % en poids de SiO₂.

2. Module photovoltaïque selon la revendication 1, **caractérisé en ce que** les films c) contenant un plastifiant, basés sur de l'acétal de polyvinyle présentent une teneur en plastifiant d'un maximum de 40 % en poids.

3. Module photovoltaïque selon la revendication 1 ou la revendication 2, **caractérisé en ce que**, dans un climat ambiant de 85 % d'humidité relative / 23°C, les films c) contenant un plastifiant, basés sur de l'acétal de polyvinyle présentent une résistance transversale électrique supérieure à 1E11 ohm*cm.

4. Module photovoltaïque selon l'une quelconque des revendications 1 à 3, **caractérisé en ce que** l'acétal de polyvinyle présente une teneur en acétate de polyvinyle inférieure à 3 % en poids.

5. Module photovoltaïque selon l'une quelconque des revendications 1 à 4, **caractérisé en ce que** l'acétal de polyvinyle présente une part d'alcool polyvinylique inférieure à 22 % en poids.

6. Module photovoltaïque selon l'une quelconque des revendications 1 à 5, **caractérisé en ce qu'**on applique une ou plusieurs couches photosensibles de semi-conducteurs b) sur un recouvrement frontal a) transparent et **en ce qu'**on les colle par au moins un film c) contenant un plastifiant, basé sur de l'acétal de polyvinyle sur le recouvrement arrière d).

7. Module photovoltaïque selon l'une quelconque des revendications 1 à 5, **caractérisé en ce qu'**on applique sur un recouvrement arrière d) une ou plusieurs couche(s) photosensibles de semi-conducteurs et **en ce qu'**ils sont collés l'un à l'autre par au moins un film c) contenant un plastifiant basé sur de l'acétal de polyvinyle sur le recouvrement frontal a) transparent.

8. Module photovoltaïque selon l'une quelconque des revendications 1 à 5, **caractérisé en ce qu'**on noie une ou plusieurs couches photosensibles de semi-conducteurs (b) entre deux films c) et on les colle avec les recouvrements a) et d).

9. Utilisation de films contenant un plastifiant, basés sur de l'acétal de polyvinyle présentant un titre alcalin supérieur à 30 par ajout de 0.05 à 1 % en poids d'un sel métallique d'un acide carboxylique avec de 1 à 15 atomes de carbone en tant que composé basique et contenant de 0.001 à 5 % en poids de SiO₂ pour la fabrication de modules photovoltaïques.

10. Utilisation de modules photovoltaïques selon l'une quelconque des revendications 1 à 7 en tant que composant de façades, que surfaces de toitures, que recouvrement de jardin d'hiver, que paroi insonorisante, qu'élément de garde-corps ou de balcon ou en tant qu'élément de surfaces de fenêtres.
